# EUROPÄISCHE PATENTANMELDUNG

(11) **EP 1 843 207 A2**
(43) Veröffentlichungstag der Anmeldung: **10.10.2007**
(21) Anmeldenummer: 07006639.4
(22) Anmeldetag: 30.03.2007
(51) Int. Cl.: G03F 7/40

(54) **Vorrichtung und Verfahren zum Behandeln von Wafern**

(30) Priorität: 04.04.2006 DE 102006015759
(71) Anmelder: ATMEL Germany GmbH, 74072 Heilbronn (DE)
(72) Erfinder: Molkenthin, Jürgen-Werner, 74243 Langenbrettach (DE); Ottenlinger, Doris, 74211 Leingarten (DE)
(74) Vertreter: Müller, Wolf-Christian

(57) **Zusammenfassung**

Die vorliegende Erfindung bezieht sich auf eine Vorrichtung sowie ein Verfahren zum Bestrahlen von Wafern mit UV-Licht niedriger Intensität, um Blistering bei der nachfolgenden Photo-Stabilisierung des Photolackes zu verhindern.

## Beschreibung

Die vorliegende Erfindung betrifft eine Vorrichtung sowie ein Verfahren zum Behandeln von Wafern gemäß der Ansprüche 1 und 5.

Integrierte Schaltungen, wie Mikroprozessoren oder Speicherchips, und andere ähnliche Baugruppen werden üblicherweise auf dünnen runden Scheiben, so genannten Wafern hergestellt. Diese unterliegen während ihrer Herstellung einer großen Anzahl an aufeinander folgenden Prozessschriten, eingeschlossen Prozeßschritte, in welchen die auf den Wafern vorhandene Fotolackmaske mittels Temperatur und ultraviolettem Licht stabilisiert wird.

Die im lithografischen Prozess erzeugte Fotolackstruktur ist gegenüber den in nachfolgenden Prozessen wie z.B. lonenimplantation- und Trockenätzprozessen auftretenden Temperaturen oder verwendeten Prozessgasen ungenügend resistent. Deshalb wird die Fotolackmaske zur Verbesserung der Selektivität bei Trockenätzprozessen und der Gleichmäßigkeit der kritischen Abmessungen sowie der Verringerung der Partikelerzeugung während des lonenimplantationsprozesses stabilisiert. Dieser Prozess ist allgemein bekannt als Photo-Stabilisierung.

Dabei wird zuerst der Fotolack mit ultraviolettem Licht bei geringer Temperatur bestrahlt, um die lichtempfindliche Komponente, die PAC (PAC = **p**hoto**a**ctive **c**omponent) zu zerstören und das Lackprofil zu stabilisieren.

Gängige lichtempfindliche PACs weisen als funktionelle chemische Gruppen z.B. cyclische, oft benzannelierte α-Diazoketone auf, wie bei der folgenden Verbindung zu sehen:

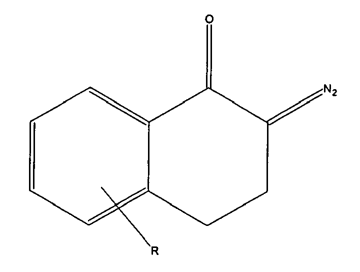

Anschließend wird bei gleichzeitiger weiterer Bestrahlung mit UV-Licht die Temperatur erhöht, um das im Fotolack noch vorhandenen Lösemittel zu entfernen und das Fotolackharz zu vernetzen.

Um die Zerstörung der PAC in kurzer Zeit zu bewerkstelligen, kommen UV-Lampen mit hoher Leistung zum Einsatz. Ausserdem richtet sich das Energie-Zeit-Profil primär nach der Vernetzung des Fotolackharzes aus.

Die Reaktion der fotoaktiven Komponente mit dem ultravioletten Licht erfolgt unter Abspaltung von Stickstoff, der durch eine Photo*-Wolff-*Umlagerung gemäß folgendem Mechanismus entsteht:

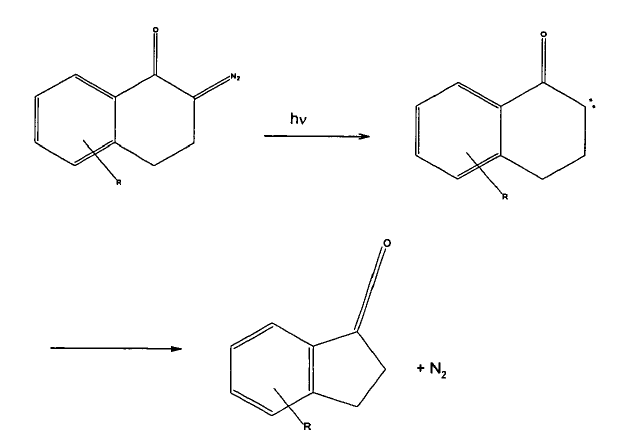

Als Reaktionsprodukt entsteht neben Stickstoff somit zunächst durch Ringverengung ein Keten, welches aber weiter z.B. zu einer (ggf. substituierten) Indolcarbonsäure hydrolysiert oder anderweitig funktionalisiert wird.

Dabei ist die Menge des entstehenden Stickstoffs proportional abhängig von der Lichtintensität des UV-Lichtes und von der Dicke des Fotolackes. Sind die Fotolackdicke und/oder die Lichtintensität sehr groß, dann kann der entstehende Stickstoff durch eine einsetzende Blasenbildung die Lackschicht zerstören. Dieser Effekt ist unter dem Namen "blistering" bekannt. Platzen die Blasen auf, dann werden Teile des Fotolackes gelöst, bekannt unter dem Namen, popping', und stellen eine Partikelquelle dar. Um diesem Effekt entgegen zu wirken, wird in modernen Anlagen zur Photo-Stabilisierung die Belichtung mit UV-Licht in einzelne Lichtblitze zerlegt, um zwischen den Blitzen den entstandenen Stickstoff entweichen zu lassen. Diese Vorgehensweise ist jedoch nicht bei allen Anwendungen geeignet, um das "blistering" wirksam zu umgehen.

Nachteilig der bekannten UV-Stabilisierungsvorrichtungen ist, dass bei verminderter Lackhaftung auf der Waferoberfläche und vorzugsweise bei Wafern mit einem Anschnitt, genannt Flat, in dessen Bereich die Lackdicke ein Mehrfaches der auf dem Wafer angestrebten Lackdicke beträgt, die oben genannten Effekte der Blasenbildung, des Platzen der Blasen und der dadurch verursachten Partikelgeneration latent vorhanden sind und auftreten.

Die dabei entstehenden Partikel können sich auf der Waferoberfläche verteilen und führen in nachfolgenden strukturierenden wie z.B. Ätz- oder Implantationsprozessen zu lokalen Maskierungen, die zu Kurzschlüssen und Unterbrechungen führen.

Diese beschriebenen Probleme treten besonders bei Wafern mit sog. "Flats" auf, da diese aufgrund der Auftragung des Photolackes durch "spin-coating" besonders im Flat-Bereich eine höhere Photolackdicke aufweisen und somit die Gefahr des Blistering ebenfalls erhöht auftritt.

Es ist somit eine Aufgabe der vorliegenden Erfindung, die Vorrichtung und ein Verfahren zur Behandlung von Wafern bereitzustellen, bei der die obigen Nachteile vermieden oder zumindest weitgehend verringert werden und die ein nachfolgendes Härten des Fotolackes ohne Qualitätsverluste an den Wafern ermöglichen.

Diese Aufgabe wird durch eine Vorrichtung gemäß Anspruch 1 sowie ein Verfahren gemäß Anspruch 5 gelöst. Dementsprechend wird eine Vorrichtung zum Bestrahlen von Wafern, insbesondere Wafern, die ein Flat aufweisen, bereitgestellt, gekennzeichnet durch mindestens eine Bestrahlungeinrichung, wobei die mindestens eine Bestrahlungseinrichtung eine Leistung von ≥2 W bis ≤300 W im Ultraviolett-Bereich aufweist.

Unter "Ultraviolett-Bereich" wird insbesondere der Bereich von ≥350 nm bis ≤450 nm verstanden.

Unter "Bestrahlungseinrichtung" im Sinne der vorliegenden Erfindung wird insbesondere eine UV-Lampe verstanden.

Es sei angemerkt, dass für den Fall, dass in der Vorrichtung mehrere Bestrahlungseinrichtungen, wie etwa zwei oder mehr UV-Lampen angeordnet sind, die "Leistung der Bestrahlungseinrichtung" It. Anspruch 1 die Summe der Einzelleistungen der einzelnen Bestrahlungseinrichtungen bedeutet; z.B. falls drei 10W UV-Lampen vorhanden sind, ist die Leistung wie in Anspruch 1 definiert 30W.

Es hat sich herausgestellt dass überraschenderweise bei einer Bestrahlung mit einer Leistung von ≥2 W bis ≤300 W im Ultraviolett-Bereich die PAC-Komponente in den meisten Anwendungen weitgehend ohne "Blistering" abreagiert und im nachfolgenden Härten in den meisten Anwendungen der vorliegenden Erfindung eine glatte Struktur erzielt werden kann.

Bevorzugt weist die mindestens eine Bestrahlungseinrichtung eine Leistung von ≥4 W bis ≤250 W, noch bevorzugt ≥6 W bis ≤200 W, ferner bevorzugt zwischen ≥8 W bis ≤100, noch bevorzugt zwischen ≥10 W bis ≤50 W sowie am meisten bevorzugt ≥12 W bis ≤20 W im Ultraviolett-Bereich auf.

Es sei angemerkt, dass gemäß einer bevorzugten Ausführungsform der vorliegenden Erfindung die gesamte Oberfläche oder im wesentlichen die gesamte Oberfläche des Wafers bestrahlt wird; gemäß einer weiteren Ausführungsform wird nur ein Teil der Oberfläche des Wafers bestrahlt.

Gemäß einer Ausführungsform der vorliegenden Erfindung wird ein Teil der Oberfläche des Wafers, der den Flat-Bereich einschliesst, bestrahlt. Bevorzugt ist dies der Flat-Bereich sowie evtl. daran angrenzende Bereiche des Wafers.

Aufgrund der erhöhten Dicke dieses Bereiches ist eine Anwendung der vorliegenden Erfindung bei diesen Wafern besonders vorteilhaft. Es hat sich herausgestellt, dass bei einigen Anwendungen innerhalb der vorliegenden Erfindung nur der Flat-Bereich durch die erfindungsgemäße Vorrichtung bzw. das erfindungsgemäßte Verfahren bestrahlt werden muss, während für den restlichen Bereich der "übliche" UV-Härtvorgang ausreicht, um ein Blistern zu verhindern.

Gemäß einer bevorzugten Ausführungsform der vorliegenden Erfindung beträgt die Bestrahlungsintensität auf dem Wafer von ≥0,5 mW/m² bis ≤2,5 mW/m², bevorzugt ≥1 mW/m² bis ≤1,5 mW/m².

Dies hat sich für eine breite Spanne von Anwendungen innerhalb der vorliegenden Erfindung als vorteilhaft herausgestellt, da so die Bestrahlung oftmals nebenreaktionsfrei abläuft.

Gemäß einer bevorzugten Ausführungsform der vorliegenden Erfindung beträgt die Lackdicke des Wafers zumindest in den durch die Bestrahlungseinrichtung bestrahlten Bereichen von ≥3*µ*m bis ≤20 *µ*m, bevorzugt ≥5*µ*m bis ≤15*µ*m.

Gemäß einer bevorzugten Ausführungsform der vorliegenden Erfindung beträgt der Abstand zwischen der Bestrahlungseinrichtung und den zu bestrahlenden Wafern zwischen ≥2 cm bis ≤40 cm.

Im Falle, dass mehrere Bestrahlungseinrichtungen in der erfindungsgemä-βen Vorrichtung vorgesehen sind, beträgt bevorzugt der durchschnittliche Abstand zwischen den Bestrahlungseinrichtungen und den zu bestrahlenden Wafern zwischen ≥2 cm bis ≤40 cm.

Für den Fall, dass mehrere Wafer in der Vorrichtung bestrahlt werden sollen, ist es bevorzugt, dass sich alle Wafer innerhalb dieses Abstandes zu der mindestens einen Bestrahlungseinrichtung befinden.

Es hat sich herausgestellt, dass in vielen Anwendungen der vorliegenden Erfindung ein gewisser Mindestabstand die Qualität der Bestrahlung erhöht; ebenso hat es sich in vielen Anwendungen herausgestellt, dass jenseits eines gewissen Abstandes die Bestrahlungsqualität abnimmt.

Bevorzugt beträgt der (durchschnittliche) Abstand zwischen der mindestens einen Bestrahlungseinrichtung und den zu bestrahlenden Wafern zwischen ≥3 cm bis ≤30 cm, noch bevorzugt ≥4 cm bis ≤20cm.

Gemäß einer bevorzugten Ausführungsform der vorliegenden Erfindung beträgt der durchschnittliche Abstand zwischen zwei zu bestrahlenden Wafern mindestens ≥0,5 mm. Es hat sich in vielen Anwendungen herausgestellt, dass ein gewisser Mindestabstand sich ebenfalls gut auf die Qualität der Bestrahlung auswirkt, um zu verhindern, dass sich ein Wafer im Strahlungsgang eines vor- oder nachfolgenden Wafers befindet.

Bevorzugt trägt der durchschnittliche Abstand zwischen zwei zu bestrahlenden Wafern zwischen ≥0,5 mm und ≤15 mm, noch bevorzugt ≥1 mm und ≤10 mm, sowie am meisten bevorzugt ≥2 mm und ≤8 mm.

Die Wafer sind in der Vorrichtung bevorzugt parallel oder im wesentlichen parallel zueinander angeordnet.

Gemäß einer bevorzugten Ausführungsform der vorliegenden Erfindung trifft das von der mindestens einen Bestrahlungseinrichtung ausgesandtem Licht in einem Winkel α zwischen ≥70° bis ≤110° auf die Wafer ein. Dies hat sich als besonders günstig für eine gleichmässige und effiziente Bestrahlung herausgestellt.

Bevorzugt trifft das von der mindestens einen Bestrahlungseinrichtung ausgesandtem Licht in einem Winkel α zwischen ≥75° bis ≤100°, noch bevorzugt ≥80° bis ≤95° auf die Wafer ein.

Gemäß einer bevorzugten Ausführungsform der vorliegenden Erfindung beträgt der Winkel β, d.h. die Fluchtlinie über die Waferkanten zwischen ≥15° bis ≤90°. Bei vielen Anwendungen innerhalb der vorliegenden Erfindung hat sich dies als günstig herausgestellt, da so besonders viele Wafer ohne Qualitätsverlust bestrahlt werden können.

Bevorzugt beträgt der Winkel β zwischen ≥20° bis ≤55°, noch bevorzugt zwischen ≥25° bis ≤40°.

Die vorliegende Erfindung bezieht sich ebenfalls auf ein Verfahren zum Bestrahlen von Wafern, insbesondere in einer Vorrichtung wie oben beschrieben, welches dadurch gekennzeichnet ist, dass die Wafer mit einer Leistung von ≥2 W bis ≤300W im Ultraviolett-Bereich bestrahlt werden.

Bevorzugt werden die Wafer mit einer Leistung von ≥4 W bis ≤250 W, noch bevorzugt ≥6 W bis ≤200 W, ferner bevorzugt zwischen ≥8 W bis ≤100, noch bevorzugt zwischen ≥1 0 W bis ≤50 W sowie am meisten bevorzugt ≥12 W bis ≤20 W im Ultraviolett-Bereich bestrahlt.

Gemäß einer bevorzugten Ausführungsform der vorliegenden Erfindung werden die Wafer in einem Abstand zwischen ≥2 cm bis ≤40 cm, ferner bevorzugt ≥3 cm bis ≤30 cm und noch bevorzugt ≥4 cm bis ≤20cm von der Strahlungsquelle bestrahlt.

Gemäß einer bevorzugten Ausführungsform der vorliegenden Erfindung trifft das zur Bestrahlung verwendete Licht in einem Winkel α zwischen ≥70° bis ≤110° ferner bevorzugt zwischen ≥75° bis ≤100° sowie noch bevorzugt ≥80° bis ≤95° auf die Wafer ein.

Gemäß einer bevorzugten Ausführungsform der vorliegenden Erfindung beträgt der Winkel β, d.h. die Fluchtlinie über die Waferkanten zwischen ≥ 15° bis ≤90°, ferner bevorzugt ≥20° bis ≤ 55° sowie noch bevorzugt zwischen ≥25° bis ≤50°.

Gemäß einer bevorzugten Ausführungsform der vorliegenden Erfindung beträgt die Bestrahlungszeit zwischen ≥1 min bis ≤40 min. Es hat sich herausgestellt, dass diese Bestrahlungszeit für nahezu alle Anwendungen der vorliegenden Erfindung ausreichend ist, um sowohl ein ausreichendes Abreagieren der PAC zu erreichen, als auch den Wafer nicht zu sehr zu belasten.

Dabei ist unter "Bestrahlungszeit" insbesondere die Zeit zu verstehen, bei der die Wafer bestrahlt werden. Diese Zeit kann nach einer Ausführungsform der Erfindung unterbrochen werden, um freigesetztem Stickstoff Zeit zu geben, aus den Wafern zu entweichen. Jedoch hat sich bei vielen Anwendungen der vorliegenden Erfindung herausgestellt, dass eine Unterbrechung der Bestrahlung nicht notwendig ist, so dass gemäß einer bevorzugten Ausführungsform der Erfindung die Bestrahlung unterbrechungsfrei erfolgt.

Bevorzugt beträgt die Bestrahlungszeit zwischen ≥2,5 min bis ≤20 min, noch bevorzugt zwischen ≥5 min bis ≤15 min.

Gemäß einer bevorzugten Ausführungsform der vorliegenden Erfindung beträgt die Energieleistung (in Leistung * Zeit) zwischen ≥50 W*min bis ≤200 W*min. Es hat sich herausgestellt, dass bei vielen Anwendungen dies für eine gute Bestrahlung ohne übermässige Belastung der Wafer vorteilhaft ist.

Unter "Zeit" ist dabei die Bestrahlungszeit zu verstehen.

Bevorzugt beträgt die Energieleistung (in Leistung * Zeit) zwischen ≥ 75 W*min bis ≤180 W*min, noch bevorzugt ≥100 W*min bis ≤150 W*min.

Gemäß einer bevorzugten Ausführungsform der vorliegenden Erfindung beträgt die Energieleistung pro *µ*m Dicke der zu bestrahlenden Fotolackschicht (in Leistung * Zeit /*µ*m Dicke) zwischen ≥5 W*min/ *µ*m bis ≤25 W*min/*µ*m.

Insbesondere bei Anwendungen, in denen vor allem der Flatbereich der Wafer bestrahlt wird, hat es sich als besonders vorteilhaft herausgestellt, die Energieleistung der Bestrahlung auf diese Weise an die Dicke der zu bestrahlenden Fotolackschicht anzupassen.

Für den Fall, dass im zu bestrahlenden Bereich der Wafer keine gleichmäßige Dicke der Photolackschicht aufweist, beträgt gemäß einer bevorzugten Ausführungsform die Energieleistung pro µm durchschnittlicher Dicke der zu bestrahlenden Fotolackschicht (in Leistung * Zeit /µm durchschnittlicher Dicke) zwischen ≥5 W*min/µm bis ≤25 W*min/µm.

Bevorzugt beträgt die Energieleistung pro µm (ggf. durchschnittlicher) Dicke der zu bestrahlenden Fotolackschicht (in Leistung * Zeit / µm Dicke) zwischen ≥8 W*min/µm bis ≤20 W*min/µm, bevorzugt ≥10 W*min/µm bis ≤ 17,5 W*min/µm.

Gemäß einer bevorzugten Ausführungsform der vorliegenden Erfindung wird die Bestrahlung so durchgeführt, dass die Temperatur des bestrahlten Wafers zumindest in den Teilen, die der Bestrahlung ausgesetzt sind, zwischen ≥15 °C bis ≤30°C beträgt.

Dies hat sich bei einer breiten Spanne von Anwendungen innerhalb der vorliegenden Erfindung als vorteilhaft herausgestellt, da so Nebenreaktionen oftmals weiter unterdrückt werden können.

Die vorgenannten sowie die beanspruchten und in den Ausführungsbeispielen beschriebenen erfindungsgemäß zu verwendenden Bauteile unterliegen in ihrer Größe, Formgestaltung, Materialauswahl und technischen Konzeption keinen besonderen Ausnahmebedingungen, so dass die in dem Anwendungsgebiet bekannten Auswahlkriterien uneingeschränkt Anwendung finden können.

Weitere Einzelheiten, Merkmale und Vorteile des Gegenstandes der Erfindung ergeben sich aus den Unteransprüchen sowie aus der nachfolgenden Beschreibung der zugehörigen Zeichnungen, in denen - beispielhaft - ein Ausführungsbeispiele einer erfindungsgemäßen Vorrichtungen dargestellt sind. In den Zeichnungen zeigt:
- Fig. 1: eine schematische perspektivische Ansicht einer Vorrichtung gemäß einer ersten Ausführungsform der Erfindung;
- Fig. 2: eine sehr schematische Seitenansicht der Wafer It. Fig. 1 zur Verdeutlichung der Winkel α und β;
- Fig. 3: eine Photographie eines Wafers in Seitenansicht nach Härtung der Photolackschicht ohne vorheriges Bestrahlen (Stand der Technik); sowie
- Fig. 4: eine Photographie eines Wafers in Seitenansicht nach Härtung der Photolackschicht, wobei zuvor eine Behandlung gemäß der Erfindung durchgeführt wurde.

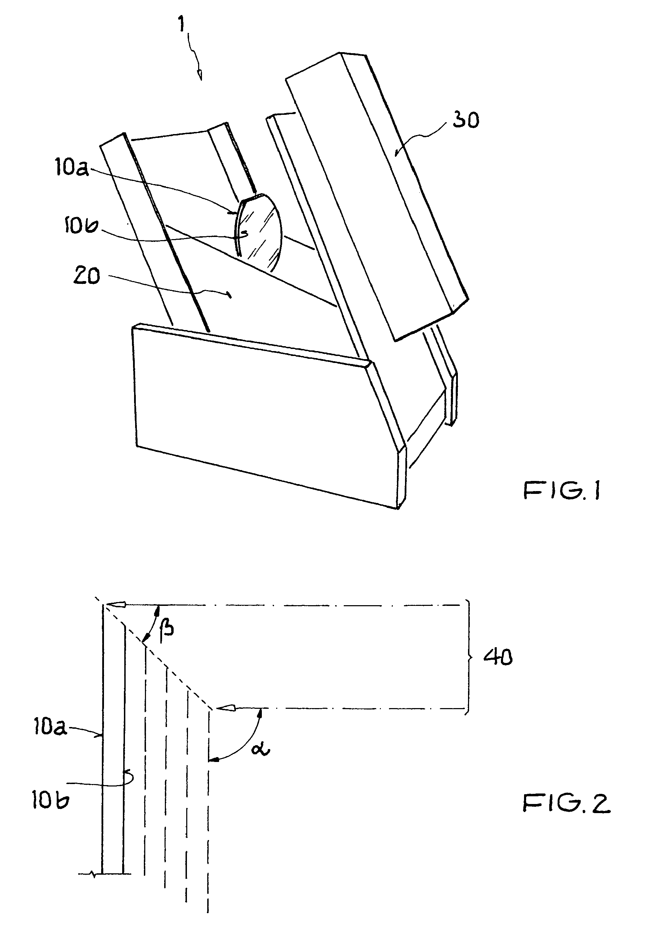

Fig. 1 zeigt eine schematische perspektivische Ansicht einer Vorrichtung 1 gemäß einer ersten Ausführungsform der Erfindung. In dieser Vorrichtung können ca. 20-30 Wafer auf einmal bestrahlt werden, in der Fig. 1 sind jedoch aus Gründen der Übersichtlichkeit nur zwei Wafer 10a, 10b gezeigt.

Die Vorrichtung umfasst eine Aufnahme 20 für die Wafer 10a, 10b; sowie eine Bestrahlungseinrichtung 30 zum Bestrahlen der Wafer. In der vorliegenden Ausführungsform besteht die Bestrahlungseinrichtung aus zwei nebeneinander angeordneten UV-Lampen, jedoch können auch sämtliche anderen dem Fachmann bekannten Bestrahlungseinrichtungen zum Einsatz kommen, soweit deren Leistung im oben beschriebenen Bereich liegt.

Die vorliegende Ausführungsform der Erfindung bezieht sich insbesondere auf Wafer, die einen Flat-Bereich aufweisen. Diese werden mit dem Flat-Bereich nach oben in die Aufnahme gestellt und dann wie oben beschrieben bestrahlt. Üblicherweise ist kein weiterer Verfahrensschritt wie eine Nachbehandlung erforderlich; die Wafer können unmittelbar weiteren Behandlungsschritten, wie der bereits beschriebenen Photo-Stabilisierung unterworfen werden.

Die Aufnahme 20 und die Bestrahlungseinrichtung 30 sind so angeordnet, dass der Winkel α (d.h. der Winkel in dem das UV-Licht auf die Wafer trifft) und der Winkel *β* (d.h. die Fluchtlinie über die Waferkanten), etwa bei 90° bzw. 20-25 ° liegen.

Zur Verdeutlichung zeigt Fig. 2 eine sehr schematische Seitenansicht der Wafer It. Fig. 1, wobei noch mehrere Wafer (in gestrichelten Linien) eingezeichnet sind. Die Fluchtlinie der Waferkanten der Wafer 10a, 10b (und noch weitere Wafer) bildet etwa einen Winkel β um 20-25°, während das UV-Licht 40 auf die Wafer 10a, 10b etwa in 90° (Winkel α) eintrifft.

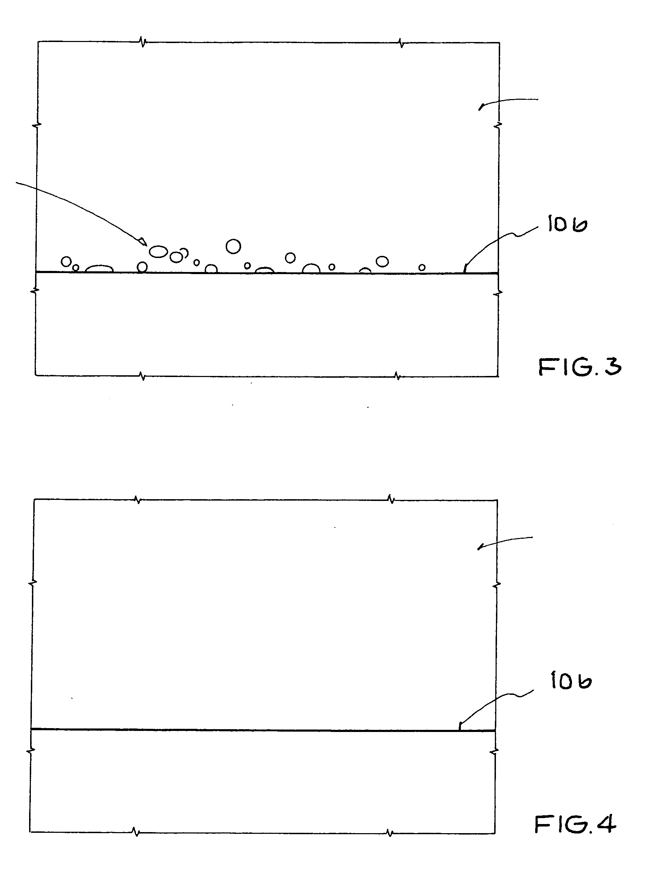

Fig. 3 zeigt eine Photographie eines Wafers in Fronansicht nach Photo-Stabilisierung der Photolackschicht ohne vorheriges Bestrahlen (Stand der Technik), Fig. 4 eine Photographie eines Wafers in Frontansicht nach Photo-Stabilisierung der Photolackschicht, wobei zuvor eine Behandlung gemäß der Erfindung durchgeführt wurde.

Man sieht, dass in der Photolackschicht in Fig. 3, d.h. einem Wafer nach dem Stand der Technik, deutlich die Blasen, die durch das freigesetzte N₂ erzeugt werden, zu sehen ist. Teilweise ist die Lackschicht in Fig. 3 sogar abgeplatzt, was die Qualität des Wafers deutlich verschlechtert.

Dagegen weisen die Wafer, die dem erfindungsgemäßen Verfahren unterworfen wurden, eine glatte Lackschicht auf, wie in Fig. 4 zu sehen.

## Patentansprüche

1. Vorrichtung zum Bestrahlen von Wafern, insbesondere Wafern, die ein Flat aufweisen,
**gekennzeichnet durch**
mindestens eine Bestrahlungeinrichung, wobei die mindestens eine Bestrahlungseinrichtung eine Leistung von 2 W bis 300 W im Ultraviolett-Bereich aufweist

2. Vorrichtung nach Anspruch 1, **dadurch gekennzeichnet, dass** der Abstand zwischen der Bestrahlungseinrichtung und den zu bestrahlenden Wafern zwischen 2 cm bis 40 cm beträgt.

3. Vorrichtung nach Anspruch 1 oder 2, **dadurch gekennzeichnet, dass** das von der mindestens einen Bestrahlungseinrichtung ausgesandtem Licht in einem Winkel zwischen 70° bis 110° auf die Wafer eintrifft.

4. Vorrichtung nach einem der Anspruch 1 bis 3, **dadurch gekennzeichnet, dass** der Winkel , d.h. die Fluchtlinie über die Waferkanten zwischen 15° bis 90° beträgt.

5. Vorrichtung nach einem der Anspruch 1 bis 4, **dadurch gekennzeichnet, dass** die die Bestrahlungsintensität auf dem Wafer von ≥0,5 mW/m² bis ≤2,5 mW/m² beträgt.

6. Verfahren zum Bestrahlen von Wafern, insbesondere in einer Vorrichtung nach einem der Ansprüche 1 bis 5,
**dadurch gekennzeichnet, dass**
die Wafer mit einer Leistung von 2 W bis 300 W im Ultraviolett-Bereich bestrahlt werden.

7. Verfahren nach Anspruch 6, **dadurch gekennzeichnet, dass** die Bestrahlungszeit zwischen 1 min bis 40 min beträgt

8. Verfahren nach Anspruch 6 oder 7, **dadurch gekennzeichnet, dass** die Energieleistung (in Leistung * Zeit) zwischen 50 W*min bis 200 W*min beträgt.

9. Verfahren nach einem der Ansprüche 6 bis 8, **dadurch gekennzeichnet, dass** die Energieleistung pro m Dicke der zu bestrahlenden Fotolackschicht (in Leistung * Zeit / m Dicke) zwischen 5 W*min/ m bis 25 W*min/ m beträgt.

10. Verfahren nach einem der Ansprüche 6 bis 9, **dadurch gekennzeichnet, dass** die Temperatur des bestrahlten Wafers zumindest in den Teilen, die der Bestrahlung ausgesetzt sind, zwischen ≥15 °C bis ≤30°C beträgt.
